# EUROPÄISCHE PATENTANMELDUNG

(11) **EP 0 535 397 A2**
(43) Veröffentlichungstag der Anmeldung: **07.04.1993**
(21) Anmeldenummer: 92115203.9
(22) Anmeldetag: 04.09.1992
(51) Int. Cl.: H03L 7/14, H03L 7/093

(54) **Schaltungsanordnung zum Synchronisieren eines spannungsgesteuerten Oszillators**

(30) Priorität: 30.09.1991 DE 9112177 U
(71) Anmelder: SIEMENS AKTIENGESELLSCHAFT, D-80333 München (DE)
(72) Erfinder: Recktenwald, Dieter, Dipl.-Ing., W-8032 Gräfelfing (DE); Reisinger, Konrad, Dipl.-Ing., W-8011 Zorneding (DE)

(57) **Zusammenfassung**

Die Schaltungsanordnung weist einen Referenztaktsignale und von dem Oszillator (VCO) her abgegebene Oszillatortaktsignale vergleichenden Phasenkomparator (Ph, FT1, FT2), eine Phasenregeleinrichtung (PR), welche nach Maßgabe von am Ausgang des Phasenkomparators auftretenden Vergleichssignalen digitale Regelsignale bereitstellt, und einen mit den digitalen Regelsignalen beaufschlagten Digital-Analog-Wandler (D/A) auf, der diesen digitalen Regelsignalen entsprechende analoge Regelspannungen an den Oszillator abgibt. Dabei ist in der Phasenregeleinrichtung (PR) eine Speicheranordnung (SP) vorgesehen, in welcher eine Mehrzahl von durch diese Phasenregeleinrichtung bereitgestellten, aufeinanderfolgenden digitalen Regelsignalen gespeichert werden. Diese werden bei Ausfall der Referenztaktsignale (RF) bereitgestellt.

## Beschreibung

Die Erfindung betrifft eine Schaltungsanordnung zum Synchronisieren eines spannungsgesteuerten Oszillators mit einem Referenztaktsignale und von dem Oszillator abgegebene Oszillatortaktsignale vergleichenden Phasenkomparator, einer nach Maßgabe der am Ausgang des Phasenkomparators auftretenden Vergleichssignalen digitale Regelsignale bereitstellenden Phasenregeleinrichtung und mit einem Digital-Analog-Wandler, welcher mit den digitalen Regelsignalen beaufschlagt ist und diesem entsprechende Regelspannungen an den Oszillator abgibt.

Eine derartige Schaltungsanordnung ist bereits bekannt (EP-B 1-0 142 826). Bei dieser bekannten Schaltungsanordnung bleibt bei Ausfall der Referenztaktsignale das zuletzt von der Regeleinrichtung ermittelte digitale Regelsignal gespeichert. Dieses Regelsignal wird dem Digital-Analog-Wandler zugeführt, um den Oszillator entsprechend einzustellen. Eine derartige Vorgehensweise bringt das Problem mit sich, daß einerseits für eine möglichst genaue Nachbildung des gespeicherten digitalen Regelsignals durch eine diesem entsprechende analoge Regelspannung ein Digital-Analog-Wandler mit einer großen Stufenanzahl erforderlich ist. Andererseits kann es durch das gerade gespeicherte Regelsignal zu einer ungenauen Einstellung des Oszillators kommen.

Es ist nun Aufgabe der vorliegenden Erfindung, einen Weg zu zeigen, wie eine Schaltungsanordnung der eingangs genannten Art ausgebildet werden kann, um gegenüber dem beim Stand der Technik vorgesehenen Digital-Analog-Wandler mit einer geringeren Stufenanzahl für einen Digital-Analog-Wandler auskommen zu können und gleichzeitig eine ausreichend genaue Einstellung des Oszillators sicherzustellen.

Gelöst wird diese Aufgabe bei einer Schaltungsanordnung der eingangs genannten Art gemäß der vorliegenden Erfindung dadurch, daß der Phasenregeleinrichtung eine Speicheranordnung für die Speicherung einer Mehrzahl von durch diese Phasenregeleinrichtung bereitgestellten, aufeinanderfolgenden Regelsignalen und für die Bereitstellung der gespeicherten digitalen Regelsignale bei Ausfall der Referenztaktsignale zugehörig ist.

Die Erfindung bringt dabei den Vorteil mit sich, daß durch das Speichern einer Mehrzahl von in aufeinanderfolgenden Regelvorgängen erzeugten digitalen Regelsignalen und deren Bereitstellen bei Ausfall der Referenztaktsignale ein Digital-Analog-Wandler geringerer Stufenanzahl verwendbar ist, an dessen Ausgang zwar entsprechend den unterschiedlichen gespeicherten digitalen Regelsignalen voneinander abweichende Regelspannungen auftreten, die jedoch im eingeschwungenen Zustand der Schaltungsanordnung im Mittel den Referenztaktsignalen entsprechen. Damit ist einerseits ein gegenüber dem beim Stand der Technik vorgesehenen Digital-Analog-Wandler kostengünstiger Digital-Analog-Wandler einsetzbar und andererseits eine ausreichend genaue Einstellung des Oszillators gewährleistet.

Zweckmäßigerweise ist die der Schaltungsanordnung gemäß der vorliegenden Erfindung zugehörige Phasenregeleinrichtung aus einer Mikroprozessoranordnung gebildet, an deren Busleitungssystem die zuvor genannte Speicheranordnung angeschlossen ist.

Im folgenden wird nun die vorliegende Erfindung anhand einer Zeichnung beispielsweise näher erläutert.

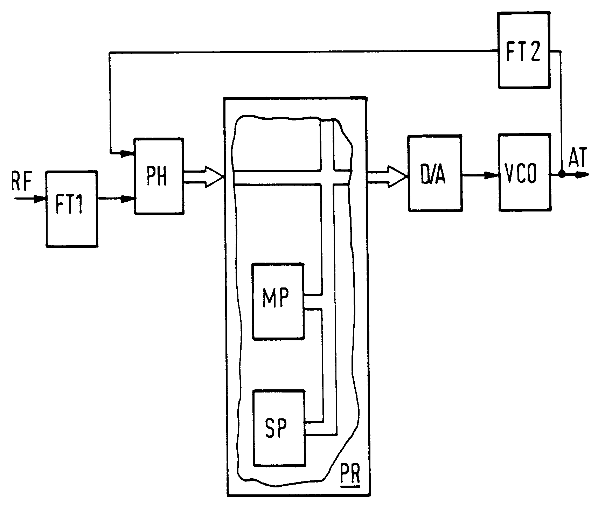

In der Zeichnung ist eine Oszillatoranordnung dargestellt, die eingangsseitig Regeltaktsignale RF zugeführt erhält. Aus diesen Referenztaktsignalen werden mit Hilfe eines Frequenzteilers FT1 interne Vergleichstaktsignale gewonnen, die ein Phasenkomparator Ph mit weiteren, aus den Ausgangstaktsignalen AT der Oszillatoranordnung durch Frequenzteilung in einem Frequenzteiler FT2 gewonnenen Vergleichstaktsignalen vergleicht. Die bei diesem Vergleich ermittelte Phasendifferenz wird in dem Phasenkomparator digitalisiert und als binäre Zahlengröße an eine Phasenregeleinrichtung PR übergeben, die bei dem hier beschriebenen Ausführungsbeispiel aus einer Mikroprozessoranordnung gebildet ist. Diese Phasenregeleinrichtung ermittelt aus den ihr zugeführten binären Zahlengrößen jeweils ein digitales Regelsignal, welches einem Digital-Analog-Wandler D/A zugeführt ist. Dieser setzt die ihm nacheinander zugeführten digitalen Regelsignalen in analoge Signale um, die einem spannungsgesteuerten Oszillator VCO als Regelspannungen zugeführt sind. Ausgangsseitig steht dieser spannungsgesteuerte Oszillator mit dem zuvor genannten Frequenzteiler FT2 in Verbindung.

Bei den von der gerade beschriebenen Oszillatoranordnung bereitzustellenden Nutztaktsignalen kann es sich entweder um die am Ausgang des Frequenzteilers FT2 auftretenden Vergleichstaktsignale oder um die am Ausgang des spannungsgesteuerten Oszillators VCO auftretenden, ggf. durch einen oder mehrere nicht dargestellte Frequenzteiler hinsichtlich ihrer Frequenz verringerten Ausgangstaktsignale AT handeln.

Wie bereits erwähnt, ist die in der Zeichnung dargestellte Phasenregeleinrichtung PR aus einer Mikroprozessoranordnung gebildet. Diese weist einen Mikroprozessor MP auf, an dessen Busleitungssystem neben dem Phasenkomparator Ph und dem Digital-Analog-Wandler D/A ein Schreib-Lese-Speicher SP angeschlossen ist. Dieser Mikroprozessor ermittelt aus den ihm von dem Phasenkomparator Ph her zugeführten binären Zahlengrößen digitale Regelsignale. Eine Mehrzahl von in aufeinanderfolgenden Regelvorgängen ermittelten digitalen Regelsignalen werden dabei in dem Schreib-Lese-Speicher SP gespeichert. Bei Ausfall der Referenztaktsignale RF werden diese gespeicherten digitalen Regelsignale fortlaufend nacheinander von dem Mikroprozessor MP abgerufen und dem Digital-Analog-Wandler D/A zugeführt. Dieses Abrufen wird für die Dauer des Ausfalls der Referenztaktsignale RF ständig wiederholt. Damit werden dem Digital-Analog-Wandler D/A digitale Regelsignale für eine Umsetzung in die genannten Regelspannungen zugeführt, die zwar hinsichtlich ihrer Werte voneinander abweichen, aber im eingeschwungenen Zustand der in der Zeichnung dargestellten Oszillatoranordnung im Mittel den ausgefallenen Referenztaktsignalen RF entsprechen. Damit ist der spannungsgesteuerte Oszillator VCO auch bei Ausfall der Referenztaktsignale RF mit einer ausreichenden Genauigkeit eingestellt.

## Patentansprüche

1. Schaltungsanordnung zum Synchronisieren eines spannungsgesteuerten Oszillators (VCO) mit einem Referenztaktsignale und von dem Oszillator (VCO) abgegebene Oszillatortaktsignale vergleichenden Phasenkomparator (Ph, FT1, FT2), einer nach Maßgabe von am Ausgang des Phasenkomparators auftretenden Vergleichssignalen digitale Regelsignale bereitstellenden Phasenregeleinrichtung (PR) und mit einem Digital-Analog-Wandler (D/A), welcher mit den digitalen Regelsignalen beaufschlagt ist und diesen entsprechende analoge Regelspannungen an den Oszillator (VCO) abgibt,
**dadurch gekennzeichnet,**
daß der Phasenregeleinrichtung (PR) eine Speicheranordnung (SP) für die Speicherung einer Mehrzahl von durch diese Phasenregeleinrichtung bereitgestellten, aufeinanderfolgenden digitalen Regelsignalen und für die Bereitstellung der gespeicherten Regelsignale bei Ausfall der Referenztaktsignale (RF) zugehörig ist.

2. Schaltungsanordnung nach Anspruch 1,
**dadurch gekennzeichnet,**
daß die Phasenregeleinrichtung (PR) aus einer Mikroprozessoranordnung (MP) gebildet ist, an deren Busleitungssystem die Speicheranordnung (SP) angeschlossen ist.
